Europäisches Patentamt

European Patent Office

Office européen des brevets

(11) Numéro de publication: **0 368 744**
**A1**

## (12) DEMANDE DE BREVET EUROPEEN

(21) Numéro de dépôt: **89403058.4**

(22) Date de dépôt: **07.11.89**

(51) Int. Cl.5: **H01L 31/039, H01L 33/00, C03C 17/34**

(30) Priorité: **10.11.88 FR 8814674**

(43) Date de publication de la demande:
**16.05.90 Bulletin 90/20**

(84) Etats contractants désignés:
**DE FR GB NL**

(71) Demandeur: **THOMSON TUBES ELECTRONIQUES**
**38, rue Vauthier**
**F-92100 Boulogne-Billancourt(FR)**

(72) Inventeur: **Henry, Yves**
**THOMSON-CSF SCPI Cédex 67**
**F-92045 Paris la Défense(FR)**

(74) Mandataire: **Guérin, Michel et al**
**THOMSON-CSF SCPI**
**F-92045 PARIS LA DEFENSE CEDEX 67(FR)**

(54) Substrat électriquement isolant.

(57) L'invention concerne un substrat (1) particulièrement destiné à porter une structure active (3) réalisée selon la technologie des films à couches minces.

Le substrat (1) selon l'invention offre l'avantage de pouvoir être réalisé en grandes dimensions et à faible coût. A cette fin, le substrat 1 comporte une plaque (4) de verre sodo-calcique passivée à l'aide de deux couches (7, 9) superposées. La couche (7) en contact avec la plaque de verre (4) est une couche barrière vis-à-vis des composants alcalins et, la couche (9) déposée sur la couche barrière (7) a pour fonction d'empêcher l'action sur la couche barrière (7) des produits destinés à graver les éléments qui constituent la structure active (3).

## SUBSTRAT ELECTRIQUEMENT ISOLANT

L'invention concerne un substrat électriquement isolant, en verre notamment, qui présente l'intérêt de pouvoir être réalisé en grande surface, de manière simple et économique. Le substrat conforme à l'invention peut avantageusement être appliqué, par exemple, au domaine des panneaux afficheurs à cristaux liquides, ou encore au domaine des dispositifs qui relèvent de la technologie des films à couches minces comme les détecteurs photosensibles à l'état solide du type barrette, ou du type surfacique, ou encore comme les structures surfaciques de diodes électroluminescentes à base de carbure de silicium amorphe hydrogéné.

Dans ces différents domaines, la réalisation de substrats en grande surface pose des problèmes qui sont ressentis avec plus ou moins d'acuité selon le domaine.

En prenant pour exemple le cas d'un détecteur d'images de type surfacique, constitué par un arrangement matriciel de points photosensibles réalisés à partir de silicium amorphe suivant la technologie des couches minces : ces détecteurs d'images doivent couramment comporter des grandes dimensions, qui pourront atteindre 40 cm x 40 cm par exemple. Dans ce type d'application, on utilise classiquement des substrats en verre exempts de produits alcalins dans leur composition : l'un des plus courants étant un borosilicate de baryum commercialisé par la firme CORNING sous la référence 7059.

Ce type de verre possède des inconvénients qui rendent difficile son utilisation industrielle. En effet, c'est un verre dur, et par suite il est très fragile sur les bords et s'écaille facilement : les particules ainsi détachées vont sur la surface, la rayent et/ou tendent à modifier ou perturber la structure active déposée sur le verre (structure qui constitue le détecteur) ce qui entraîne de nombreux défauts ponctuels. De plus, ce verre étant très dur, il est très difficile à couper, et il est souvent brisé quand il s'agit de le couper selon de grandes surfaces, notamment 40 cm x 40 cm. Ceci tend à augmenter le coût, alors que déjà l'achat de ce verre en grande surface est d'un coût particulièrement élevé compte-tenu des critères de planéité qui sont nécessaires.

Il existe cependant des verres du type sodocalcique dits verres à vitres, qui sont faciles à couper et largement disponibles sur le marché à un prix relativement faible. Mais ce type de verre présente l'inconvénient d'être riche en oxyde de sodium. Si l'on dépose par exemple du silicium amorphe sur un support ou substrat en verre d'un tel type, les produits alcalins présents dans le verre diffusant dans le silicium amorphe et par suite la structure active rapportée sur ce substrat vieillit mal et se décolle de son support après quelques mois.

Une solution classique à ce problème consiste à passiver le verre en déposant sur la surface de ce dernier une couche de protection, appelée couche barrière, qui est ainsi interposée entre le verre et la première couche de la structure active à laquelle le verre sert de support ; la fonction de la couche barrière est de faire barrière aux produits indésirables contenus dans le verre support, c'est-à-dire dans le cas présent d'empêcher la diffusion des alcalins dans le silicium amorphe.

Dans cet esprit il est possible d'utiliser du verre sodo-calcique passivé à la silice (la couche de silice étant généralement déposée à partir d'une phase liquide d'un organo-métallique de silicium). Mais le substrat constitué en verre sodo-calcique ainsi traité n'est fait qu'en très faible quantité, et par suite il est très difficile à approvisionner dans le cadre d'une fabrication industrielle.

La présente invention concerne un substrat qui ne présente pas les inconvénients ci-dessus cités. Le substrat conforme à l'invention est constitué à partir d'un verre de type sodo-calcique comportant une couche barrière aux alcalins, et la composition de la couche barrière est telle qu'elle offre l'avantage, notamment, de pouvoir être réalisée avec des moyens semblables à ceux qui sont utilisés pour le dépôt de couches de silicium amorphe.

Selon l'invention, un substrat électriquement isolant, comportant une plaque de verre de type sodo-calcique, est caractérisé en ce qu'au moins une face de la plaque de verre est recouverte d'au moins une couche barrière vis-à-vis des composants alcalins de la plaque de verre, et en ce qu'au moins une couche d'arrêt de gravure est déposée sur la couche barrière.

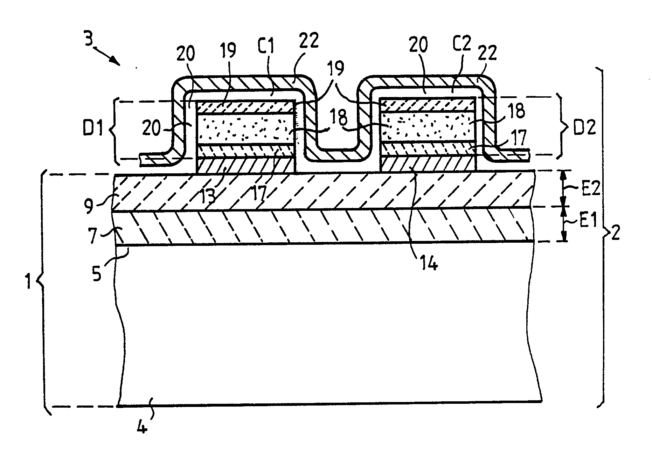

L'invention sera mieux comprise à l'aide de la description qui suit, faite à titre d'exemple non limitatif, en référence à la figure unique annexée qui montre schématiquement, par une vue en coupe, un substrat conforme à l'invention portant une structure active.

La figure représente de manière schématique, à titre d'exemple non limitatif, un substrat 1 conforme à l'invention, utilisé dans un dispositif photosensible 2, c'est-à-dire que le substrat 1 porte un structure active 3 qui est une structure photosensible (par structure active nous entendons définir tout élément auquel le substrat 1 peut servir de support).

Le substrat 1 est constitué à partir d'une plaque de verre 4 de type sodo-calcique.

Selon une caractéristique de l'invention, d'une part, une face 5 de la plaque de verre 4, orientée vers la structure active 3, est recouverte d'au moins une couche barrière 7 faisant office de barrière vis-à-vis des alcalins et qui est donc destinée à empêcher la diffusion des alcalins dans la structure active 3 ; d'autre part, la couche barrière 7 est eue-même recouverte d'au moins une couche 9 appelée couche d'arrêt de gravure qui est ainsi disposée entre la couche barrière 7 et la structure active 3.

Par le terme "couche barrière vis-à-vis des alcalins", nous entendons définir une couche de tout matériau capable d'empêcher la diffusion des composants alcalins, contenus dans la plaque de verre 4 sodo-calcique, vers la structure active 3 ; ce matériau susceptible de constituer la couche barrière 7 étant par exemple du silicium carburé hydrogéné amorphe a-Si$_{1-x}$C$_x$ : H, ou encore du nitrure de silicium hydrogéné amorphe a-Si N$_z$ : H.

Il est à noter en outre que par le terme "couche d'arrêt de gravure" nous entendons définir une couche de tout matériau non gravable par les mêmes produits ou mélanges gazeux que ceux utilisés pour la gravure des éléments de la structure active 3 et notamment du silicium amorphe, ou dont l'attaque par ces mélanges s'effectue beaucoup plus lentement : ainsi par exemple, la couche d'arrêt de gravure 9 peut être une couche de silice amorphe hydrogénée a-Si O$_y$ : H (qui résiste bien à la gravure par les procédés de gravure classiques en microélectronique utilisés pour le silicium amorphe et les métaux, à savoir notamment la gravure humide et la gravure plasma), ou encore par exemple une couche d'oxynitrure de silicium amorphe hydrogéné a-Si O$_u$ N$_{1-u}$: H avec u proche de 1.

La réalisation du substrat 1 peut s'effectuer par exemple de la manière expliquée ci-après. La plaque de verre 4 sodo-calcique est nettoyée par des procédés connus. La plaque de verre 4 est ensuite introduite dans une chambre d'un réacteur du type utilisé pour les dépôts chimiques en phase vapeur en présence d'un plasma, en basse pression (PECVD du terme anglais Plasma Enhanced Chemical Vapor Deposition), où la plaque de verre 4 est portée à une température par exemple de l'ordre de 200°C à 300°C.

Dans une version préférée de l'invention, un mélange d'éthylène C$_2$H$_4$, et de silane Si H$_4$ est excité par une onde radiofréquence à 13,56 MHz par exemple, pendant une durée déterminée d'une manière en elle-même classique, par les épaisseurs de dépôts à obtenir. On dépose ainsi une couche de silicium carburé hydrogéné amorphe a-Si$_{1-x}$C$_x$ : H.

La composition de ce matériau formant la couche barrière 7 peut varier préférentiellement par exemple de x = 0,55 à x = 0,75, correspondant à une composition du mélange gazeux

C$_2$H$_4$/(C$_2$H$_4$ + Si H$_4$) = 0,8 à 0,9 respectivement (il est à noter néanmoins que des résultats satisfaisants ont été constatés pour des valeurs de x comprises entre 0,5 et 1). Les largeurs de bandes interdites E$_g$ du matériau formant la couche barrière 7 varient de E$_g$ = 2,6 eV pour x = 0,55 à E$_g$ = 2,8 eV pour x = 0,75 ; ces valeurs étant utiles pour obtenir une bonne isolation électrique (résistivité plus grande que 1.10$^{10}$ ohm-cm à l'obscurité).

L'épaisseur E1 de la couche barrière 7 en silicium carburé hydrogéné amorphe peut être comprise par exemple entre 0,5 et 1 micromètre, et dans cette gamme d'épaisseur, elle permet d'obtenir un excellent recouvrement des défauts de surface de la plaque de verre 4.

Il est à noter qu'il est possible de remplacer l'éthylène par du méthane CH$_4$, mais dans ce cas la valeur de x que l'on peut atteindre ne dépasse pas beaucoup 0,6.

La couche barrière 7 de silicium carburé hydrogéné amorphe 7 est ensuite recouverte par la couche d'arrêt de gravure 9 en silice amorphe hydrogénée ; cette couche d'arrêt de gravure 9 ayant par exemple une épaisseur E2 de l'ordre de 1 micromètre et étant déposée par une méthode de dépôt conventionnelle comme dans le cas du dépôt de la couche de barrière 7, c'est-à-dire par une méthode de dépôt chimique en phase vapeur par exemple, à partir d'un mélange de silane Si H$_4$ et de protoxyde d'azote N$_2$O.

L'intérêt du dépôt de la couche de barrière 7 sur la plaque de verre 4, puis du dépôt de la couche d'arrêt de gravure 9 qui est ainsi située entre la couche barrière 7 et la structure active 3, est le suivant : le bon pouvoir de recouvrement des défauts de surface de la plaque de verre 4 par la couche barrière 7 de silicium carburé hydrogéné amorphe permet d'obtenir une barrière efficace à la diffusion du sodium, (on peut remarquer que la couche faite de silicium carburé hydrogéné amorphe est plus dense que la silice) ; les lacunes étant occupées par l'hydrogène qui reste stable tant que les procédés qui suivent (pour réaliser la structure active 3) sont élaborés à une température égale ou inférieure à celle du dépôt de la couche barrière 7 en silicium carburé hydrogéné amorphe. Par contre ce matériau qui constitue la couche barrière 7 est gravable par les mêmes procédés c'est-à-dire par les mêmes mélanges que ceux qui permettent de graver le silicium amorphe, de sorte que lors de la fabrication de la structure active 3 ou structure détectrice, le verre de la plaque 4 peut être remis à nu. Aussi, la couche de silice amorphe hydrogénée a-Si O$_y$ : H a pour rôle d'isoler la couche barrière 7 vis-à-vis des gaz de gravure destinés à graver le silicium amorphe que comporte la structure active 3 ; la silice amorphe de la couche d'arrêt gravure 9 ne se gravant pas, ou fort lentement, par les mêmes mélanges gazeux que ceux destinés à la gravure du silicium amorphe.

La plaque de verre 4 ainsi traitée constitue le susbtrat 1 qui peut être utilisé alors comme un substrat ordinaire pour toute la suite des opérations de réalisation de la structure active 3.

Dans l'exemple non limitatif décrit, la structure active 3, déposée sur la couche d'arrêt gravure 9, correspond à une structure décrite dans un brevet français 86. 00716 qui se rapporte à une matrice d'éléments photosensibles comportant un réseau de conducteurs en ligne, et un réseau de conducteurs en colonne, avec, à chaque croisement d'une ligne et d'une colonne, un point photosensible constitué par une photodiode en série avec une capacité. Bien entendu, le substrat de l'invention peut s'appliquer aussi bien à des points photosensibles de structures différentes.

Ainsi en prenant pour exemple la structure décrite dans le brevet ci-dessus cité, on trouve au-dessus de la couche 9 d'arrêt de gravure, une couche métallique qui est gravée de sorte à constituer des conducteurs colonnes 13, 14 qui s'étendent dans un plan perpendiculaire à celui de la figure (seulement deux conducteurs colonnes sont représentés pour simplifier la figure). Une diode D1, D2 de type PIN par exemple, est formée par dépôt sur les conducteurs de colonne 13, 14, de trois couches de silicium amorphe 17, 18, 19 respectivement dopées de type P (couche 17), de type intrinsèque (couche 18) et de type N (couche 19) ; une couche isolante 20 est déposée sur l'ensemble des diodes D1, D2, cette couche 20 constituant le diélectrique d'une capacité C1, C2 qui a été précédemment citée comme étant en série avec la photodiode D1, D2. On trouve ensuite une couche métallique conductrice, de préférence transparente, qui est déposée sur la couche isolante 20 et gravée pour former des conducteurs de ligne 22 de la matrice (un unique conducteur ligne 22 vu en coupe étant représenté sur la figure). Bien entendu la structure active 3 qui vient d'être décrite est en elle-même classique, et dans l'esprit de l'invention le substrat 1 conforme à l'invention peut servir de substrat pour des montages et des applications différentes.

Comme il a été mentionné précédemment, dans une variante de l'invention, il peut être utilisé pour constituer la couche barrière 7, du nitrure de silicium hydrogéné a-Si $N_z$ : H, qui possède aussi un excellent pouvoir de recouvrement des défauts de surface du verre, et qui a également une très bonne rigidité diélectrique et qui constitue une barrière efficace à la diffusion du sodium.

Cependant, les couches de nitrure de silicium hydrogéné sont toujours très contraintes, et il en résulte des pertes d'adhérence des structures de détecteurs ou structures actives 3 sur tout ou partie de la surface. Le nitrure de silicium hydrogéné est en forte compression par rapport au verre, la valeur de contrainte dans la couche étant d'environ -3 $10^{10}$ Dyn/cm$^2$ pour une épaisseur d'environ 0,3 micromètre.

Toutefois, la couche barrière 7 est revêtue elle-même d'une couche d'arrêt de gravure 9 en silice amorphe hydrogénée, de sorte que dans le cas où la couche barrière 7 est constituée en nitrure de silicium hydrogénée, la couche suivante 9 d'arrêt de gravure permet d'obtenir un ensemble formé de ces deux couches 7, 9 qui n'est plus qu'en très légère compression.

Ainsi, un premier dépôt d'une couche barrière 7 en nitrure de silicium hydrogéné a-Si $N_z$ est réalisé d'une manière en elle-même classique, à une température de l'ordre de 200°C à 300°C, avec une épaisseur E1 de 0,3 micromètre environ. Ce dépôt de la couche barrière 7 en nitrure de silicium hydrogéné est suivi du dépôt de la couche d'arrêt gravure 9 d'une épaisseur E2 d'environ 0,6 μm dans ce dernier cas, c'est-à-dire nettement plus grande que l'épaisseur E1 de la couche barrière 7 en nitrure de silicium hydrogéné. Comme il a été ci-dessus mentionné, l'ensemble des deux couches 7, 9 se trouve alors en très légère compression à environ -4 $10^8$ Dyn/cm$^2$. On dispose alors d'un susbtrat 1 formé à partir d'un verre sodo-calcique passivé compatible avec l'adhérence des couches des structures actives 3.

Le substrat conforme à l'invention peut être utilisé de manière avantageuse dans tous les cas il doit être réalisé en grande dimension, à partir du verre, et où il est nécessaire d'éviter une contamination des éléments auxquels ce substrat sert de support. Ainsi par exemple le substrat de l'invention peut être utilisé de manière particulièrement intéressante comme support de dispositif qui met en oeuvre la technologie des films à couches minces, avec notamment l'utilisation de silicium amorphe comme dans le cas des détecteurs photosensibles.

## Revendications

1 - Substrat électriquement isolant, comportant une plaque (4) de verre de type sodo-calcique, caractérisé en ce qu'au moins une face (5) de la plaque de verre (4) est recouverte d'au moins une couche barrière (7) vis-à-vis des composants alcalins de la plaque (4) de verre, et en ce qu'au moins une couche (9) d'arrêt de gravure est déposée sur la couche barrière (7).

2 - Substrat selon la revendication 1, caractérisé en ce que la couche barrière (7) est en silicium carburé hydrogéné amorphe a-Si$_{1-x}$ C$_x$ : H avec x compris entre 0,5 et 1.

3 - Substrat selon la revendication 1, caractérisé en ce que la couche barrière (7) est en nitrure de silicium hydrogéné a-Si $N_z$ : H.

4 - Substrat selon l'une des revendications précédentes, caractérisé en ce que la couche (9) d'arrêt de gravure est en silice amorphe hydrogéné a-Si $O_y$ : H.

5 - Substrat selon l'une des revendications 1 ou 2 ou 3, caractérisé en ce que la couche (9) d'arrêt de gravure est en oxynitrure de silicium amorphe hydrogéné a-SiO$_u$N$_{1-u}$ :H .

6 - Substrat selon la revendication 3, caractérisé en ce que la couche (9) d'arrêt de gravure est en silice amorphe hydrogéné a-Si $O_y$ : H et comporte une épaisseur (E2) plus grande que l'épaisseur (E1) de la couche barrière (7).

7 - Substrat selon l'une des revendications précédentes, caractérisé en ce que la couche barrière (7) est déposée sur la plaque (4) de verre par une méthode de dépôt chimique en phase vapeur.

8 - Substrat selon l'une des revendications précédentes, caractérisé en ce qu'il constitue le substrat d'un dispositif (1) du type films à couches minces.

9 - Substrat selon la revendication 8, caractérisé en ce qu'il constitue le susbtrat d'un détecteur photosensible (3) comportant du silicium amorphe.

10 - Substrat selon la revendication 8, caractérisé en ce qu'il constitue le substrat d'un dispositif à diodes électroluminescentes réalisées à partir de carbure de silicium.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 275 662 (PILKINGTON PLC) <br> * Pages 1-6; revendications * <br> --- | 1,4,5,7 | H 01 L 31/039 <br> H 01 L 33/00 <br> C 03 C 17/34 |
| A | DE-A-3 423 159 (CANON K.K.) <br> * Revendications 1,2,4; pages 4,5; page 6, lignes 1-10; page 7, ligne 19 - page 8, ligne 26; page 9, lignes 2-20; figure 1 * <br> --- | 1,7-9 | |
| A | EP-A-0 154 482 (STC PLC) <br> * Revendications; page 4, lignes 16-27 * <br> --- | 1-3,7 | |
| A | US-A-4 187 336 (R.G. GORDON) <br> * Colonne 8, ligne 26 - colonne 10, ligne 35; colonne 11, ligne 66 - colonne 13, ligne 5 * <br> --- | 1,4,7 | |
| A | US-A-4 451 838 (S. YAMAZAKI) <br> --- | | |
| A | PATENT ABSTRACTS OF JAPAN, vol. 1, no. 145, 25 novembre 1977, page 7279 E 77; & JP-A-52 82 442 (SUWA SEIKOSHA K.K.) 09-07-1977 <br> ----- | | **DOMAINES TECHNIQUES RECHERCHES (Int. Cl.5)** <br><br> H 01 L <br> G 02 F <br> C 03 C |

Le présent rapport a été établi pour toutes les revendications

| Lieu de la recherche | Date d'achèvement de la recherche | Examinateur |
|---|---|---|
| LA HAYE | 29-01-1990 | VISENTIN A. |